# EUROPÄISCHE PATENTANMELDUNG

(11) **EP 4 621 354 A1**
(43) Veröffentlichungstag der Anmeldung: **24.09.2025**
(21) Anmeldenummer: 25161872.4
(22) Anmeldetag: 05.03.2025
(51) Int. Cl.: G01D 5/20

(54) **ERFASSUNGSVORRICHTUNG FÜR EINEN LAGEGEBER UND ERFASSUNGSSYSTEM MIT EINER SOLCHEN ERFASSUNGSVORRICHTUNG**

(30) Priorität: 18.03.2024 DE 102024107561
(71) Anmelder: SUMIDA Components & Modules GmbH, 94130 Obernzell (DE)
(72) Erfinder: Simon, Markus, 94116 Hutthurm (DE); Krohn, Philipp, 94127 Neuburg am Inn (DE)
(74) Vertreter: Grünecker Patent- und Rechtsanwälte PartG mbB

(57) **Zusammenfassung**

Die Erfindung stellt in anschaulichen Ausführungsformen eine Erfassungsvorrichtung für einen Lagegeber, vorzugsweise einen Rotorlagegeber, mit einer Leiterplatte bereit. Diese Erfassungsvorrichtung umfasst eine Primärwicklung und wenigstens eine Sekundärwicklung, wobei wenigstens eine von der Primärwicklung und der wenigstens einen Sekundärwicklung wenigstens teilweise durch einen wickelbaren Leiterdraht ausgebildet ist. Weiterhin umfasst die Erfassungsvorrichtung einen Vorrichtungskörper, wobei der Leiterdraht der Primärwicklung und/oder der wenigstens einen Sekundärwicklung vollständig auf einem Oberflächenabschnitt einer Oberfläche des Vorrichtungskörpers angebracht ist.

## Beschreibung

### Gebiet der Erfindung

Die vorliegende Erfindung betrifft eine Erfassungsvorrichtung für einen Lagegeber, vorzugsweise einen Rotorlagegeber, und ein Erfassungssystem mit einer solchen Erfassungsvorrichtung. Insbesondere betrifft die vorliegende Erfindung eine Erfassungsvorrichtung, die in einem Lagegeber eingesetzt wird, um zusammen mit einem Geberelement, das relativ zur Erfassungsvorrichtung drehbar angeordnet ist, eine Winkellage des Geberelements relativ zur Erfassungsvorrichtung zu erfassen.

### Hintergrund

In vielen technischen Bereichen ist es erforderlich, die Position eines sich bewegenden Objekts mit einer durch die jeweiligen Einsatzzwecke vorgegebenen Genauigkeit zu bestimmen. Zu diesem Zweck wurden zahlreiche Sensorsysteme entwickelt, in denen zumindest die relative Position zwischen zwei Elementen mit ausreichend hoher Präzision durch beispielsweise optische, elektrische, magnetische und andere Wechselwirkungen gemessen werden kann. Insbesondere in technischen Bereichen, in denen sehr anspruchsvolle Umgebungsbedingungen vorherrschen, etwa hohe Betriebstemperaturen in Verbindung mit hohen magnetischen Feldern, die z. B. durch hohe Betriebsströme hervorgerufen werden können, werden häufig Sensoranordnungen eingesetzt, in denen die positionsabhängige Erzeugung von Wirbelströmen zur Ermittlung der Position einer Komponente herangezogen wird. Dazu wird in einigen Beispielen einer derartigen Wirbelstromsensoranordnung vorgesehen, die eine durch Wirbelströme hervorgerufene Dämpfung einer oder mehrerer Spulen erfasst, wobei die eine oder mehreren Spulen als ortsfeste Komponenten vorgesehen sind und eine bewegte Komponente eine Spur aus einem geeigneten Material aufweist, die zu einer positionsabhängigen Wirbelstromerzeugung und damit Dämpfung führt. Auf der Grundlage dieser positionsabhängigen Wirbelstromerzeugung kann somit durch eine Korrelation der hervorgerufenen Dämpfung und der besonderen Gestalt der Spur die Position der sich bewegenden Spur mit Bezug auf die eine oder mehreren ortsfesten Spulen bestimmt werden.

Eine beispielhafte Anwendung in dieser Hinsicht ist die Bestimmung der Lage eines Rotors einer elektrischen Maschine, um damit geeignete Ansteuersignale für das Zuführen geeigneter Strom- und Spannungswerte zu ermitteln. Beispielsweise ist es in vielen Fällen, in denen sehr variable Drehgeschwindigkeiten und eine moderat große Steuerungsbandbreite für die elektrische Maschine erforderlich sind, wichtig, Ausgangsspannungssignale von Sensorsystemen mit einer hohen zeitlichen Auflösung zu erfassen, um relativ präzise die Lage des Rotors bestimmen zu können. Im Hinblick auf eine effiziente Betriebsweise von etwa permanent erregten Synchronmaschinen ist es z.B. erforderlich, die Stellung des Rotors entsprechend der Polzahl innerhalb eines Winkelabschnitts mit guter Genauigkeit zu kennen, um Statorwicklungen geeignet zu bestromen, so dass sich eine gewünschte Betriebsweise einstellt. Häufig werden dazu berührungslose, auf Spulen beruhende Sensoranordnungen eingesetzt, die jedoch einen relativ großen Bauraum für die Spulen und die damit verbundene Auswertungselektronik benötigen. Häufig ist eine räumlich sehr enge Kopplung zwischen Geberelement und Rotor in der elektrischen Maschine erforderlich, wobei in der Nähe des Geberelements hohe Ströme mit entsprechend hohen Magnetfeldern, wie auch relativ hohe Temperaturen auftreten, die zu Störungen in den Ausgangssignalen der Spulen führen. Diese Störanfälligkeit resultiert letztendlich auch in einer schlechteren räumlichen Auflösung der Lage eines Rotors. Neben einer gewünschten Störsicherheit im Hinblick auf hohe magnetische Felder ist im Hinblick auf Sensoranordnung für elektrische Maschinen aber auch eine Anpassung der Sensoranordnungen an die Betriebsbedingungen der elektrischen Maschine erwünscht, beispielsweise im Hinblick auf die vorherrschenden Temperaturen, den erforderlichen Drehzahlbereich, und dergleichen.

Zusätzlich zu den obigen Gesichtspunkten bestehen unabhängig von einer konkreten Anwendung im Hinblick auf die Bereitstellung und Integration von Komponenten eines Sensorsystems die Erfordernisse einer hohen gleichbleibenden Präzision bei einer Fertigung von Sensoranordnungen, etwa in der Massenfertigung. Dies erlaubt eine gleichmäßige Funktion von Sensoranordnungen ohne aufwendige Justierarbeiten bei der Installation in der Endanwendung.

Handelsübliche Auswerteschaltung verwenden im Allgemeinen eine großflächige Primärspule die mindestens zwei sinusförmige Sekundärspulen umschließt. Im Betrieb eines Rotorlagegebers mit einer solchen Auswerteschaltung ändert ein rechteckiges Geberelement die Kopplung zwischen der Primärspule und den Sekundärspulen, die als Planarspulen in Leiterplattentechnik realisiert sind. Gewöhnliche Auswerteschaltungen für Rotorlagegeber stellen eine kreisförmige Leiterplatte in Multilayer-Technik mit vier Lagen bereit, wobei die Planarspulen für Primär- und Sekundärspulen für gewöhnlich auf zwei der vier Lagen ausgebildet sind, während weitere Lagen für eine integrierte Schaltung der Auswerteschaltung bereitgestellt sind.

Die Schrift DE 10 2016 202 877 B3 zeigt einen Drehwinkelsensor mit einem Statorelement, das eine Sendespule und wenigstens zwei innerhalb der Sendespule angeordnete Empfangsspulen aufweist, die auf einer Leiterplatte angeordnet sind, und einem bezüglich des Statorelements um eine Drehachse drehbar gelagerten Rotorelement, über das die Sendespule mit den wenigstens zwei Empfangsspulen induktiv gekoppelt ist, so dass die induktive Kopplung von einem Drehwinkel zwischen dem Statorelement und dem Rotorelement abhängig ist und die Sendespule in den wenigstens zwei Empfangsspulen wenigstens zwei winkelabhängige Wechselspannungen induziert. Das Rotorelement und die wenigstens zwei Empfangsspulen sind derart ausgebildet, dass in den Empfangsspulen eine Wechselspannung induziert wird, deren Amplitude sinusförmig von dem Drehwinkel abhängig ist. Die wenigstens zwei Empfangsspulen sind aus miteinander elektrisch verbundenen kreisbogenförmigen Leiterbahnen aufgebaut, so dass jede der wenigstens zwei Empfangsspulen aus bezüglich eines Stromflusses gegenläufig orientierten Teilwindungen aufgebaut ist, von denen jede in einer radialen Richtung von wenigstens einer nach links gekrümmten kreisbogenförmigen Leiterbahn und wenigstens einer gegenüberliegenden nach rechts gekrümmten kreisbogenförmigen Leiterbahn begrenzt ist.

Aus der Schrift DE 11 2019 006 893 T5 ist ein planarer linearer induktiver Positionssensor bekannt, der ein Substrat, mindestens eine Schwingspule, eine erste Sensorspule mit gegenüberliegenden Kanten, die sich über die gegenüberliegenden Kanten der Schwingspule entlang einer linearen Achse erstrecken, entlang der eine lineare Position eines leitfähigen Objekts erfasst werden soll, und eine zweite Sensorspule mit gegenüberliegenden Kanten umfasst, die sich über gegenüberliegende Kanten der Schwingspule entlang der Linearachse erstrecken. Die erste Sensorspule und die zweite Sensorspule weisen dabei Geometrien auf, die derart ausgewählt sind, dass gleiche entgegengesetzte Magnetfelder in der ersten und der zweiten Sensorspule bei Vorhandensein eines von der Schwingspule erzeugten Magnetfeldes induziert werden, wenn sich kein leitfähiges Messobjekt in der Nähe der ersten und der zweiten Sensorspule befindet, und ungleiche entgegengesetzte Magnetfelder in der ersten und der zweiten Sensorspule induziert werden, wenn sich das leitfähige Messobjekt in der Nähe der ersten und der zweiten Sensorspule befindet. Dabei korreliert ein Unterschied in den ungleichen entgegengesetzten Magnetfeldern, die in der ersten und der zweiten Sensorspule induziert werden, mit der Position des leitfähigen Messobjekts.

Da sich der Preis einer Leiterplatte primär nach der Anzahl ihrer Lagen und der benötigen Fläche richtet, sind die oben beschriebenen handelsüblichen Auswerteschaltungen hochpreisig.

Angesichts des oben dargestellten Stands der Technik ist es eine Aufgabe, eine Erfassungsvorrichtung für einen Lagegeber und ein Erfassungssystem mit einer solchen Erfassungsvorrichtung bereitzustellen, die geringere Herstellungskosten erfordern im Vergleich zu herkömmlichen Vorrichtungen und Systemen.

### Zusammenfassung

In verschiedenen Aspekten der Erfindung werden Erfassungsvorrichtungen und Erfassungssysteme zur Lagebestimmung von einem relativ zu einem Bezugsobjekt bewegten und/oder verlagerten Objekt eingesetzt, wie zum Beispiel ohne Beschränkung in Rotorlagegebern zur Winkelbestimmung von einem relativ zu einem Bezugsobjekt verdrehten oder rotierenden Objekt.

Die oben angegebene Aufgabe wird in verschiedenen Aspekten durch das gemeinsame erfinderische Konzept gelöst, dass die durch Leiterplatten in herkömmlichen Lagegebern hervorgerufenen Kosten bei erfindungsgemäßen Erfassungsvorrichtungen und Erfassungssystemen mit solchen Erfassungsvorrichtungen reduziert werden. Dies wird durch den wenigstens teilweisen Ersatz von kostspieligen Leiterplatten durch kostengünstige Leiterplatten oder durch Drahtwicklungen wenigstens teilweise ausgeführt durch Leiterdraht außerhalb einer Leiterplatte erreicht.

Leiterdraht bedeutet einen wickelbaren Leiterdraht, der beispielweise auf einen zylindrischen Spulenträger zeitweise zur Lagerung aufgewickelt sein kann und bei Bedarf von dem Spulenträger abgewickelt werden kann. Der Leiterdraht stellt ein im Gegensatz zu einer Leiterbahn auf einer Leiterplatte oder dergleichen eine selbsttragende Struktur dar, während die Leiterbahn auf einer Leiterplatte gebildet als eine abgeschiedene und strukturierte Bahn, die nicht unabhängig von der Leiterplatte vorhanden ist. Der Leiterdraht gemäß der vorliegenden Beschreibung existiert an sich und unabhängig davon, ob er auf einer Leiterplatte angebracht ist. In diesem Sinne sind "wickelbarer Leiterdraht" und "selbsttragender Leiterdraht" als intrinsische Merkmale zu verstehen, die den Leiterdraht als solchen als einen Leiterdraht im ursprünglichen Wortsinn bezeichnen, der einen elektrisch leitfähigen Draht als eigenständiges strukturelles Merkmal unabhängig von einer weiteren Struktur, wie einer Oberfläche, einem Träger, einer Leiterplatte usw. bezeichnet. In der vorliegenden Anmeldung sind "wickelbarer Leiterdraht" und "selbsttragender Leiterdraht" austauschbar.

In einem ersten Aspekt stellt die vorliegende Erfindung eine Erfassungsvorrichtung für einen Lagegeber bereit, wie z.B. ein Rotorlagegeber oder allgemein ein Lagegeber, der nicht nur eine Lage eines Rotors einer elektrischen Maschine, sondern eine Lage eines beliebigen rotierenden Teils erfasst, wie etwa eines Teils, das beispielsweise über ein Getriebe an einen Rotor einer elektrischen Maschine angeflanscht ist, oder ein rotierendes Teil, welches nur in einem begrenzten Winkelbereich oder kontinuierlich rotiert.

Dabei wird im ersten Aspekt der Erfindung eine Erfassungsvorrichtung bereitgestellt, die für einen Lagegeber mit einer Leiterplatte vorgesehen ist. Die Erfassungsvorrichtung kann in speziellen anschaulichen Ausführungsformen des ersten Aspekts als eine Erfassungsvorrichtung für Rotorlagegeber bereitgestellt werden.

In den anschaulichen Ausführungsformen des ersten Aspekts umfasst die Erfassungsvorrichtung einen Vorrichtungskörper, eine Primärwicklung und wenigstens eine Sekundärwicklung, wobei wenigstens eine von der Primärwicklung und der wenigstens einen Sekundärwicklung wenigstens teilweise durch einen Leiterdraht ausgebildet ist, wobei der Leiterdraht der Primärwicklung und/oder der Leiterdraht der wenigstens einen Sekundärwicklung vollständig auf einem Oberflächenabschnitt des Vorrichtungskörpers angebracht ist.. Die Primärwicklung und/oder die wenigstens eine Sekundärwicklung können zum Beispiel vollständig durch Leiterdraht gebildet sein, wobei der Leiterdraht der Primärwicklung und/oder der Leiterdraht der wenigstens einen Sekundärwicklung vollständig auf dem Oberflächenabschnitt einer Oberfläche des Vorrichtungskörpers angebracht ist. Beispielsweise kann der Leiterdraht der Primärwicklung und/oder der wenigstens einen Sekundärwicklung vollständig auf dem Oberflächenabschnitt des Vorrichtungskörpers angebracht sein. Beispielsweis kann der Leiterdraht mittels eines Klebers an dem Oberflächenabschnitt angeklebt sein. Alternativ kann der Leiterdraht durch Erhitzen in den Oberflächenabschnitt wenigstens teilweise versenkt sein.

In anschaulichen Ausführungsformen ist der Vorrichtungskörper frei von jeglichen elektrischen und/oder elektronischen Komponenten darin, so dass in den Vorrichtungskörper keine elektrischen und/oder elektronischen Komponenten integriert sind. Der Vorrichtungskörper dient lediglich als Träger für die Primärwicklung und/oder Sekundärwicklung(en) und optional für eine Leiterplatte zur Montage auf einer Oberfläche des Vorrichtungskörpers.

Gemäß der Beschreibung hierin ist der Leiterdraht ein Drahtleiter, der aus einem Drahtstück gebildet sein kann. Beispielsweise kann das Drahtstück ein Stück eines Runddrahts oder Flachdrahts, wobei der Leiterdraht vollständig auf dem Oberflächenabschnitt einer Oberfläche des Vorrichtungskörpers montiert ist. Der Leiterdraht bildet hierbei wenigstens teilweise eine auf dem Oberflächenabschnitt des Vorrichtungskörpers angeordnete Planarspule von wenigstens einer von der Primärwicklung und der wenigstens einen Sekundärwicklung aus. Die Primärwicklung und/oder Sekundärwicklung kann gemäß anschaulicher Beispiele vollständig aus Runddraht oder Flachdraht gebildet sein.

Eine entsprechend bereitgestellte Erfassungsvorrichtung kann unter geringen Herstellungskosten bereitgestellt werden, wobei der Vorrichtungskörper als Spulenkörper bzw. Träger für die Primär- und Sekundärwicklungen der Erfassungsvorrichtung fungiert. Beispielsweise kann ein als Spritzgusskörper bereitgestellter Vorrichtungskörper unter geringen Herstellungskosten leicht in großen Stückzahlen mit großer Genauigkeit bzw. Reproduzierbarkeit hergestellt werden kann. Ein entsprechender Vorrichtungskörper stellt auch ein nachhaltiges Bauteil bereit, da es im Zuge einer Gleichteilverwendung mit einer Leiterplatte verwendbar ist, die für mehrere Projekte verwendet werden kann, da eine mit der erfindungsgemäßen Erfassungsvorrichtung zu verwendende Leiterplatte nicht mehr in Größe und Gestalt dahingehend festgelegt ist, dass sie als Vorrichtungskörper der Erfassungsvorrichtung zu fungieren hat.

In verschiedenen anschaulichen Ausführungsformen hierin dient der Vorrichtungskörper höchstens teilweise, vorzugsweise gänzlich nicht als Leiterplatte der Erfassungsvorrichtung und der Vorrichtungskörper ist höchstens teilweise, vorzugsweise gänzlich nicht als Leiterplatte der Erfassungsvorrichtung bereitgestellt. Zum Beispiel kann der Vorrichtungskörper völlig unabhängig von einer Leiterplatte der Erfassungsvorrichtung vorgesehen bzw. ausschließlich als zusätzliches Element neben einer Leiterplatte und den Wicklungen in der Erfassungsvorrichtung bereitgestellt sein. Damit ist der Leiterdraht der Primärwicklung und/oder der Leiterdraht der wenigstens einen Sekundärwicklung vollständig unabhängig von, insbesondere außerhalb einer Leiterplatte auf einem Oberflächenabschnitt des Vorrichtungskörpers angebracht, beispielsweise kann der Leiterdraht der Primärwicklung und/oder der wenigstens einen Sekundärwicklung vollständig auf einem Oberflächenabschnitt einer Oberfläche des Vorrichtungskörpers und außerhalb einer Leiterplatte angebracht sein.

In anschaulichen Ausführungsformen des ersten Aspekts umfasst diese Erfassungsvorrichtung eine Primärwicklung und wenigstens eine Sekundärwicklung, wobei wenigstens eine von der Primärwicklung und der wenigstens einen Sekundärwicklung wenigstens teilweise durch einen Leiterdraht ausgebildet ist, und einen Vorrichtungskörper. Dabei ist der Leiterdraht der Primärwicklung und/oder der wenigstens einen Sekundärwicklung vollständig auf einem Oberflächenabschnitt des Vorrichtungskörpers angebracht.

In vorteilhaften Ausgestaltungen kann der Vorrichtungskörper leicht auf mehre Polpaarzahlen abgestimmt werden und die Primär- und/oder Sekundärwicklungen können zumindest teilweise unabhängig von einer Leiterplatte realisiert werden.

In einigen anschaulichen und nicht beschränkenden Beispielen des ersten Aspekts können eine Primärwicklung und zwei Sekundärwicklungen an dem Vorrichtungskörper angebracht sein, wobei eine präzise Lagebestimmung im Betrieb für einen Lagegeber mit dieser Erfassungsvorrichtung ermöglicht wird.

In einer ersten Ausführungsformen des ersten Aspekts kann der Leiterdraht als Planarspulenabschnitt verlegt sein. Zum Beispiel kann der Leiterdraht mit einem sinusförmigen Spulenverlauf im Planarspulenabschnitt verlegt sein. Hierbei kann eine kompakte Erfassungsvorrichtung mit reduzierter Bauhöhe erreicht werden.

In einer zweiten Ausführungsformen des ersten Aspekts kann der Vorrichtungskörper eine Nut aufweisen, in der der Leiterdraht der Primärwicklung und/oder der wenigstens einen Sekundärwicklung vollständig verlegt ist. Die Nut kann wenigstens teilweise in dem Oberflächenabschnitt des Vorrichtungskörpers gebildet sein, beispielsweise als eine flache Nut in dem Oberflächenabschnitt des Vorrichtungskörpers. Hierbei ist eine flache Nut eine Nut, in der eine Tiefe der Nut (gemessen als eine Abmessung der Nut entlang einer Richtung parallel zu einer Flächennormalen des Oberflächenabschnitts in den Vorrichtungskörper hinein) kleiner ist als jede senkrecht dazu gemessene Abmessung der Nut, beispielsweise wenigstens um den Faktor 5 oder 10 oder 20 kleiner. Durch den in der Nut verlegten Leiterdraht kann vermieden werden, dass der Leiterdraht merklich von dem Vorrichtungskörper weg hervorsteht, so dass eine Beschädigung von Wicklungen im Betrieb vermieden werden kann. Weiterhin kann eine Bauhöhe der Erfassungsvorrichtung verringert werden.

In anschaulichen Beispielen der zweiten Ausführungsform kann die Nut einen Spulenaufnahmenutabschnitt aufweisen, vorzugsweise ausgebildet als ringförmiger Nutabschnitt im Vorrichtungskörper, der lateral durch Stegabschnitte und in der Oberfläche des Vorrichtungskörpers begrenzt ist. Damit kann auf einfache Weise ein Verguss im Spulenaufnahmenutabschnitt verlegten Wicklungen erfolgen, wobei die Stege die Nut seitlich festlegen.

In weiteren anschaulichen Beispielen der zweiten Ausführungsform kann die Nut ferner einen Leiterplattenaufnahmebereich aufweisen, der zur vollständigen Aufnahme einer Leiterplatte ausgebildet ist, wobei die Nut lediglich auf einer Oberfläche des Vorrichtungskörpers ausgebildet ist. Durch Bereitstellung einer entsprechenden Nut kann eine Erfassungsvorrichtung mit geringer Bauhöhe bereitgestellt werden, wenn an dem Vorrichtungskörper eine Leiterplatte angebracht wird.

In einer dritten Ausführungsformen des ersten Aspekts kann der Vorrichtungskörper als ein plattenförmiger oder scheibenförmiger Körper ausgebildet sein und die Nut kann in einer Oberfläche des Vorrichtungskörpers gebildet sein, die senkrecht zu einer kleinsten Abmessung des Vorrichtungskörpers orientiert ist. Dies stellt eine vorteilhafte Ausgestaltung des Vorrichtungskörpers in Anwendungen gerichtet auf Winkellageerfassung dar, beispielsweise für einen Rotorlagegeber.

In einer vierten Ausführungsformen des ersten Aspekts kann die Erfassungsvorrichtung ferner eine Leiterplatte umfassen, die an dem Vorrichtungskörper angebracht und mit der Primärwicklung und/oder der wenigstens einen Sekundärwicklung auf dem Vorrichtungskörper verbunden ist. Es kann nun eine Leiterplatte in Form und Größe unabhängig von der beabsichtigten Anwendung der Erfassungsvorrichtung gewählt werden, wobei es nun möglich ist, eine sehr kompakte Leiterplatte zu wählen bzw. eine bestehende Erfassungsvorrichtung auf einfache und kostengünstige Weise nachträglich durch Austausch von Leiterplatten zu konfigurieren. Beispielsweise können Leiterplatten mit minimaler Fläche, d.h., einer lediglich von der auf bzw. in die Leiterplatte integrierte Schaltung festgelegten Fläche, und mit einer geringen Anzahl von Lagen, bzw. weniger als vier Lagen wie etwa nur zwei Lagen oder nur einer Lage, verwendet werden.

In einer fünften Ausführungsformen des ersten Aspekts kann die Leiterplatte einen Flächenbereich des Vorrichtungskörpers von weniger als 19.000 mm² aufweisen. In anschaulichen Beispielen hierin kann der Flächenbereich höchstens 18.500 mm² oder höchstens 18.000 mm² oder höchstens 15.000 mm² oder höchstens 10.000 mm² oder höchstens 5.000 mm² betragen. Beispielweise kann der Flächenbereich höchstens 3.000 mm² bedecken, wie etwa höchstens 2.000 mm² oder höchstens 1.500 mm² oder höchstens 1.300 mm². Es kann beispielsweise eine sehr kompakte und damit kostengünstige Leiterplatte ohne Beschränkung des Leistungsvermögens von integrierten Schaltungen auf der Leiterplatte zu wählen.

In einer sechsten Ausführungsformen des ersten Aspekts kann die Leiterplatte weniger als vier Lagen umfassen. Beispielsweise kann die Leiterplatte höchstens zwei Lagen aufweisen.

In einer siebten Ausführungsformen des ersten Aspekts kann die Leiterplatte ausschließlich Kontakte, diskrete elektrische Bauteile und eine integrierte Schaltung aufweisen. Hierin sind die Kontakte durch Leiterbahnen mit den elektrischen Bauteilen verbunden und die elektrischen Bauteile stellen wenigstens einen Kondensator und/oder wenigstens einen Widerstand diskrete Bauteile bereit. Durch die Kontakte kann die Leiterplatte mit den Primär- und Sekundärwicklungen verbunden sein. Weiterhin kann die integrierte Schaltung wenigstens einen Teil einer integrierten Auswertungs- und/oder Ansteuerschaltung darstellen, die mit der Primärwicklung und/oder der wenigstens einen Sekundärwicklung verbunden ist. Dabei sind auf der Leiterplatte lediglich die Komponenten und Leiterbahnen mit minimalster Länge vorgesehen, so dass eine sehr kompakte Ausgestaltung der Leiterplatte ermöglicht wird.

In einem zweiten Aspekt wird eine Erfassungsvorrichtung für einen Lagegeber, vorzugsweise einen Rotorlagegeber, mit einer Leiterplatte bereitgestellt. In anschaulichen Ausführungsformen hierin umfasst die Erfassungsvorrichtung gemäß dem zweiten Aspekt eine Primärwicklung und wenigstens eine Sekundärwicklung, wobei wenigstens eine von der Primärwicklung und der wenigstens einen Sekundärwicklung wenigstens teilweise durch einen Leiterdraht ausgebildet ist, einen Vorrichtungskörper, und eine Leiterplatte, die an dem Vorrichtungskörper in Verbindung mit dem Leiterdraht von wenigstens einer von der Primärwicklung und der wenigstens einen Sekundärwicklung angebracht ist. Der Leiterdraht der Primärwicklung und/oder der Leiterdraht der wenigstens einen Sekundärwicklung ist hierbei vollständig außerhalb der Leiterplatte auf einem Oberflächenabschnitt des Vorrichtungskörpers angebracht, beispielsweise kann der Leiterdraht der Primärwicklung und/oder der wenigstens einen Sekundärwicklung vollständig auf einem Oberflächenabschnitt einer Oberfläche des Vorrichtungskörpers angebracht sein.

Der Leiterdraht stellt hierbei einen Drahtleiter gebildet aus einem Drahtstück dar, beispielsweise ein Stück eines Runddrahts oder Flachdrahts, wobei der Leiterdraht vollständig auf dem Oberflächenabschnitt der Oberfläche des Vorrichtungskörpers außerhalb der Leiterplatte verlegt und montiert ist. Der Leiterdraht bildet hierbei wenigstens teilweise eine auf dem Oberflächenabschnitt des Vorrichtungskörpers angeordnete Planarspule von wenigstens einer von der Primärwicklung und der wenigstens einen Sekundärwicklung aus.

Eine entsprechend bereitgestellte Erfassungsvorrichtung kann unter geringen Herstellungskosten bereitgestellt werden, wobei der Vorrichtungskörper als Spulenkörper bzw. Träger für die Primär- und Sekundärwicklungen der Erfassungsvorrichtung fungiert. Beispielsweise kann ein als Spritzgusskörper bereitgestellter Vorrichtungskörper unter geringen Herstellungskosten leicht in großen Stückzahlen mit großer Genauigkeit bzw. Reproduzierbarkeit hergestellt werden kann. Ein entsprechender Vorrichtungskörper stellt auch ein nachhaltiges Bauteil bereit, da es im Zuge einer Gleichteilverwendung mit einer Leiterplatte verwendbar ist, die für mehrere Projekte verwendet werden kann, da eine mit der erfindungsgemäßen Erfassungsvorrichtung zu verwendende Leiterplatte nicht mehr in Größe und Gestalt dahingehend festgelegt ist, dass sie als Vorrichtungskörper der Erfassungsvorrichtung zu fungieren hat.

In verschiedenen anschaulichen Ausführungsformen hierin ist der Vorrichtungskörper höchstens teilweise, vorzugsweise gänzlich nicht als Leiterplatte der Erfassungsvorrichtung bereitgestellt. Zum Beispiel kann der Vorrichtungskörper völlig unabhängig von einer Leiterplatte der Erfassungsvorrichtung vorgesehen bzw. ausschließlich als zusätzliches Element neben einer Leiterplatte und den Wicklungen in der Erfassungsvorrichtung bereitgestellt sein.

In anschaulichen Ausgestaltungen des zweiten Aspekts kann die Erfassungsvorrichtung gemäß dem zweiten Aspekt ferner wenigstens ein weiteres Merkmal aufweisen, das in einer der Ausführungsformen des ersten Aspekts definiert ist, insbesondere eine der ersten bis fünften Ausführungsformen des ersten Aspekts.

In einem dritten Aspekt wird eine Erfassungsvorrichtung für einen Lagegeber, vorzugsweise einen Rotorlagegeber, mit einer Leiterplatte bereitgestellt. In anschaulichen Ausführungsformen hierin umfasst die Erfassungsvorrichtung gemäß dem zweiten Aspekt wenigstens zwei miteinander elektrisch verbundene Leiterplatten. Ferner umfasst die Erfassungsvorrichtung gemäß dem dritten Aspekt eine Primärwicklung und wenigstens eine Sekundärwicklung, wobei wenigstens eine von der Primärwicklung und der wenigstens einen Sekundärwicklung als eine wenigstens teilweise integrierte Verdrahtung wenigstens teilweise in wenigstens eine der wenigstens zwei Leiterplatten integriert ist. Es kann durch die Verwendung von mehreren Leiterplatten zumindest eine der Leiterplatten als eine relativ kostengünstige Leiterplatte für die teilweise integrierte Verdrahtung verwendet werden, so dass Herstellungskosten für die Erfassungsvorrichtung reduziert werden.

In anschaulichen Ausführungsformen des dritten Aspekts können die wenigstens zwei Leiterplatten eine Leiterplatte mit lediglich zwei Lagen und eine Leiterplatte mit mehr als zwei Lagen umfassen. Dabei wird durch die Leiterplatte mit lediglich zwei Lagen eine relativ günstige Leiterplatte gegenüber der Leiterplatte mit mehr als zwei Lagen bereitgestellt. Die Leiterplatte mit mehr als zwei Lagen kann als Leiterplatte vorgesehen sein, in die zusätzliche integrierte Schaltungsstrukturen integriert sein können, so dass eine Verwendung von hochpreisigen Leiterplatten durch die weitere Verwendung einer Leiterplatte mit lediglich zwei Lagen reduziert werden kann. Beispielsweise kann in die Leiterplatte mit mehr als zwei Lagen ferner wenigstens ein Teil einer Auswertungs- und Ansteuerschaltung für eine oder mehrere der damit verbundenen Wicklungen integriert sein, und/oder wenigstens eine Wicklung kann vollständig in die Leiterplatte mit lediglich zwei Lagen integriert sein.

In weiteren anschaulichen Ausführungsformen des dritten Aspekts kann die Erfassungsvorrichtung ferner einen Vorrichtungskörper umfassen, wie zum Beispiel einen Spritzgusskörper. An dem Vorrichtungskörper können die wenigstens zwei Leiterplatten angebracht sein. Alternativ oder zusätzlich kann wenigstens eine von der Primärwicklung und der wenigstens einen Sekundärwicklung höchstens teilweise durch einen Leiterdraht ausgebildet sein. Damit kann eine für Wicklungen verwendete Fläche ohne eine Verwendung von Leiterplatten vorgesehen werden, so dass Herstellungskosten weiterhin reduziert werden können.

In einem vierten Aspekt wird ein Erfassungssystem bereitgestellt. In anschaulichen Ausführungsformen umfasst das Erfassungssystem eine Erfassungsvorrichtung gemäß wenigstens einem der ersten bis dritten Aspekte und ein Geberelement, das relativ zur Erfassungsvorrichtung drehbar angeordnet ist, wobei das Geberelement eine Geberstruktur aufweist, die aus einem elektrisch leitfähigen Material gebildet ist. Damit übertragen sich die Vorteile und positiven Effekte der Erfassungsvorrichtung gemäß dem ersten und/oder zweiten und/oder dritten Aspekt auf das Erfassungssystem gemäß dem vierten Aspekt.

Im Erfassungssystem des vierten Aspekts wird in vorteilhafter Weise eine Winkellage zwischen Erfassungsvorrichtung und Geberelement erfasst, wenn das Geberelement relativ zur Erfassungsvorrichtung bewegt wird. Beispielsweise kann eine relative Drehbewegung zwischen Geberelement und Erfassungsvorrichtung durch eine Drehbewegung eines Läufers, in speziellen Anwendungen kann dies ein Rotor einer elektrischen Maschine sein, eine in den Sekundärwicklungen induzierte Spannung in Abhängigkeit von einer momentanen Position des Geberelements zu der Erfassungsvorrichtung erzeugen. In anderen Worten wird ein von der Primärwicklungsschaltung erzeugtes magnetisches Feld durch das Geberelement moduliert und das modulierte magnetische Feld induziert in den Sekundärwicklungen der Erfassungsvorrichtung ein Spannungssignal, das ein durch eine Geberstruktur des Geberelements moduliertes Signal des elektrischen Signals darstellt, das an die Primärwicklungsschaltung angelegt wird, wobei die Geberstruktur entlang eines Umlaufs des Geberelements bezüglich der Erfassungsvorrichtung eine winkelabhängig variierende Form bzw. Gestalt der Geberstruktur aufweist.

In einem fünften Aspekt wird ein Verfahren zur Herstellung einer Erfassungsvorrichtung für einen Lagegeber, vorzugsweise einen Rotorlagegeber, mit einer Leiterplatte bereitgestellt. In anschaulichen Ausführungsformen umfasst das Verfahren ein Bereitstellen eines wickelbaren Leiterdrahtes, ein Bereitstellen eines einen Vorrichtungskörpers, ein Bereitstellen von einer Primärwicklung und/oder wenigstens einer Sekundärwicklung, wobei wenigstens eine von der Primärwicklung und der wenigstens einen Sekundärwicklung wenigstens teilweise durch den wickelbaren Leiterdraht auf einer Oberfläche des Vorrichtungskörpers gebildet wird, und ein Bereitstellen einer Leiterplatte, die an dem Vorrichtungskörper in Verbindung zu wenigstens einer von der Primärwicklung und der wenigstens einen Sekundärwicklung an dem Vorrichtungskörper angebracht wird.

In der Erfassungsvorrichtung gemäß dem ersten Aspekt und/oder zweitem Aspekt und/oder dritten Aspekt können die Primär- und Sekundärwicklungen als Luftspulen bereitgestellt sein, was bedeutet, dass die Primär- und Sekundärwicklungen ohne einen magnetisierbaren Kern bereitgestellt sind. In diesem Fall tragen externe Magnetfelder aufgrund des Fehlens eines magnetischen Kernmaterials in der Spule nicht oder nur in tolerierbarem Maße zu einer Aufmagnetisierung oder auch Sättigung bei, so dass das gewonnene Ausgangssignal relativ störunanfällig ist, beispielsweise gegenüber den großen Magnetfeldern, die in elektrischen Maschinen auftreten. Somit können Wirbelstromverluste der Geberstruktur, wenn diese zumindest teilweise aus einem elektrisch/magnetisch leitenden Material aufgebaut ist, zur Beeinflussung der Ausgangssignale der Erfassungsvorrichtung ausgenutzt werden, so dass die Erfassungsvorrichtung gemäß dem ersten und/oder zweiten und/oder dritten Aspekt im Hinblick auf elektromagnetische Einflüsse störfest ist.

Das Verfahren gemäß dem fünften Aspekt kann zur Herstellung einer Erfassungsvorrichtung nach einem der ersten bis vierten Aspekte verwendet werden, wobei die Ausführungsformen aus jedem der ersten bis vierten Aspekte in den fünften Aspekt hineinkombiniert werden können.

### Kurze Beschreibung der Zeichnungen

Weitere Vorteile und anschauliche Ausführungsformen der oben dargestellten Aspekte der Erfindung werden nachfolgend mit Bezug auf die beiliegenden Figuren beschrieben, wobei:
- Fig. 1: schematisch eine Aufsicht auf eine Erfassungsvorrichtung gemäß einiger anschaulicher Ausführungsformen in ebener Ansichten zeigt, wobei die Ansicht in Fig. 1b eine Schnittansicht entlang der Linie 1b-1b in Fig. 1a darstellt;
- Fig. 2a und 2b: schematisch in Aufsicht jeweils eine Lage einer Leiterplatte gemäß anschaulichen Ausführungsformen zeigen; und
- Fig. 3: eine schematische Darstellung eines Erfassungssystems gemäß einigen anschaulichen Ausführungsformen zeigt.

### Detaillierte Beschreibung

Verschiedene nachfolgend beschriebene anschauliche Ausführungsformen können eine Anwendung von Erfassungsvorrichtungen in Rotorlagegebern betreffen, ohne per se auf diese Anwendung beschränkt zu sein, sofern dies nicht explizit angegeben ist.

Gemäß anschaulichen beispielhaften Ausführungsformen umfasst ein Rotorlagegeber allgemeinen ein Erfassungssystem zur Erfassung einer Winkellage zwischen einer Erfassungsvorrichtung des Erfassungssystems und einem Geberelement des Erfassungssystems.

Beispielsweise kann das Geberelement als relativ zur Erfassungsvorrichtung bewegtes Bezugsobjekt oder als feststehendes Bezugsobjekt gegenüber einer dazu bewegten Erfassungsvorrichtung angesehen sein. Das Geberelement weist dabei eine Geberstruktur auf, die aus einem elektrisch/magnetisch leitfähigen Material gebildet ist und sich bei einer vollständigen Drehung (d.h. eine Drehung um 360° um eine Drehachse des Geberelements relativ zur Erfassungsvorrichtung) winkelabhängig ändert, wodurch eine Winkellage zwischen Erfassungsvorrichtung und Geberelement erfasst wird.

In Rotorlagegebern mit passivem Geberelement weist die Erfassungsvorrichtung eine Primärwicklungsschaltung auf, die ein magnetisches Feld erzeugt, das durch die Geberstruktur des Geberelements moduliert wird. Ein entsprechend moduliertes magnetisches Feld induziert wiederrum in wenigstens einer Sekundärwicklung der Erfassungsvorrichtung entsprechend modulierte elektrische Signale. Aus einem Vergleich zwischen einem elektrischen Signal, das an die Primärwicklungsschaltung zur Erzeugung des magnetischen Felds angelegt ist, und dem elektrischen Signal, das durch die wenigstens eine Sekundärwicklung darauf in Antwort ausgeben wird, kann auf eine Winkellage zwischen Geberelement und Erfassungsvorrichtung geschlossen werden.

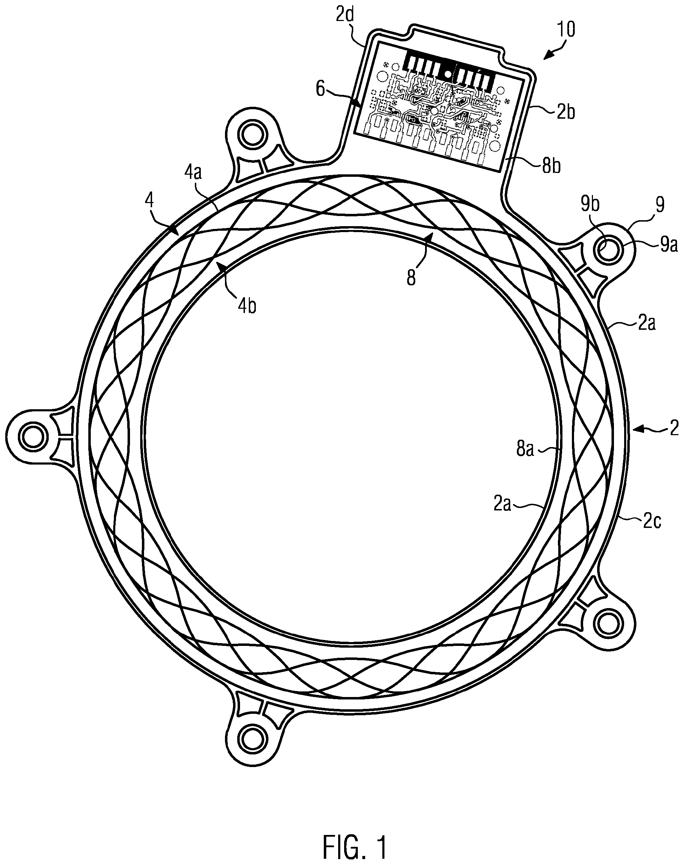

Mit Bezug auf die Fig. 1 wird eine Erfassungsvorrichtung 10 für einen Rotorlagegeber gemäß einer anschaulichen Ausführungsform der Erfindung zur Erfassung einer Winkellage zwischen der Erfassungsvorrichtung 10 in einem Erfassungssystem (nicht dargestellt) und einem Geberelement (nicht dargestellt) des Erfassungssystems (nicht dargestellt) beschrieben.

Fig. 1 zeigt schematisch in einer Aufsicht die Erfassungsvorrichtung 10 mit einem Vorrichtungskörper 2 und einer Wicklungsstruktur 4, die an dem Vorrichtungskörper 2 angebracht ist. Die Wicklungsstruktur 4 kann gemäß der dargestellten Ausführungsform eine Primärwicklung 4a und mindestens eine Sekundärwicklung 4b (etwa zwei Sekundärwicklungen in der in Fig. 1 dargestellten Ausführungsform, obgleich auch mehr als zwei Sekundärwicklungen bereitgestellt sein können, wie etwa vier Sekundärwicklungen oder mehr Sekundärwicklungen).

In anschaulichen Beispielen der in Fig. 1 dargestellten Ausführungsform kann der Vorrichtungskörper 2 als ein einfach und kostengünstig herzustellender Trägerkörper, insbesondere als Spulenträgerkörper geeigneter Körper, bereitgestellt werden. Beispielsweise kann der Vorrichtungskörper 2 als ein Spritzgusskörper bereitgestellt werden, wobei dieser Vorrichtungskörper 2 einfach und reproduzierbar hergestellt werden kann. Als speziell anschauliche Beispiele für mögliche Materialien zur Herstellung des Vorrichtungskörpers 2 können ohne Beschränkung thermoplastischen Kunststoffe umfassen, die durch Additive und Füllstoffe für eine Spritzgießverarbeitung und eine spätere konkrete Verwendung des Vorrichtungskörpers 2 in einem konkreten Anwendungsfall ergänzt sein können, beispielsweise ohne Beschränkung in einer Anwendung als Vorrichtungskörper für einen Lagegeber im Fahrzeugbau.

Zum Beispiel können Materialien zur Herstellung des Vorrichtungskörpers 2 ohne Beschränkung mindestens eines aus Polyolefine, Polypropylen, Plexiglas (PMMA), Polycarbonat (PC), Polystyrol (PS), Copolymere von PS (ABS = Acrylnitril-Butadien-Styrol), Polyamid (PA), Polyoxymethylen (POM) und vielen weiteren technischen Kunststoffen.

Mit Bezug auf die Darstellung in Fig. 1 ist der Vorrichtungskörper 2 durch einen Spulenträgerkörperabschnitt 2a und einem optionalen Leiterplattentrageabschnitt 2b gebildet, wobei der optionale Leiterplattenabschnitt 2b integral mit dem Spulenträgerkörperabschnitt 2a ausgebildet und zum Tragen einer optionalen Leiterplatte 6 ausgebildet sein kann. Beispielsweise kann der Spulenträgerkörperabschnitt 2a eine Gestalt aufweisen, die auf eine Form und Gestalt der Wicklungsstruktur 4 abgestellt bzw. dadurch bestimmt ist. Mit Bezug auf Fig. 1 ist der Spulenträgerkörperabschnitt 2a als ein ringförmiger Vorrichtungskörperabschnitt ausgebildet. Dies stellt jedoch keine Beschränkung dar und, abhängig von einer Anwendung in einem linearen Lagegeber, kann der Spulenträgerkörperabschnitt 2a anstelle eines ringförmigen Vorrichtungskörperabschnitts einen linearen bzw. länglichen oder langgestreckten Vorrichtungskörperabschnitt aufweisen, ohne dass dadurch die folgende Beschreibung davon berührt ist. Insbesondere hängt die vorangegangene und folgende Beschreibung von weiteren strukturellen und funktionalen Merkmalen der Erfassungsvorrichtung 10 in Fig. 1 nicht von der gestaltlichen Ausführung des Spulenträgerkörperabschnitt 2a ab, sofern es nicht explizit angegeben ist.

In anschaulichen Beispielen kann der Vorrichtungskörper 2 als ein plattenförmiger oder scheibenförmiger Körper ausgebildet sein. Insbesondere kann der Spulenträgerkörperabschnitt 2a als ein scheibenförmiger Körper ausgebildet sein. Die Begriffe "scheibenförmig" und "plattenförmig" sind dahingehend zu verstehen, dass eine kleinste Abmessung des Körpers normal zu einer Oberfläche orientiert ist, auf der die Wicklungsstruktur 4 angeordnet ist.

Mit weiterem Bezug auf Fig. 1 ist der Leiterplattenabschnitt 2b quer zu einer Erstreckungsrichtung der Wicklungsstruktur 4 orientiert und erstreckt sich quer zur Erstreckungsrichtung der Wicklungsstruktur 4 von dem Spulenträgerkörperabschnitt 2a weg. Die Erstreckungsrichtung der Wicklungsstruktur 4 ist als eine Richtung definiert, entlang der sich ein Leiterdraht der Wicklungsstruktur 4 zwischen Anschlüssen hauptsächlich erstreckt, wobei der Begriff "hauptsächlich" als einen Anteil von mehr als 50% gemessen von einer Gesamtlänge, insbesondere mehr als 70%, verstanden wird. Der Leiterplattenabschnitt 2b ist von einer ausreichenden Größe, um die Leiterplatte 6 zu halten, so dass die Leiterplatte 6 mittels des Leiterplattenabschnitts 2b an dem Vorrichtungskörper 2 montierbar ist. Unter dem Begriff "montierbar" ist eine dauerhafte oder lösbare Anbringung zu verstehen.

In anschaulichen Beispielen, wie in Fig. 1 dargestellt ist, können die Primärwicklung 4a und die Sekundärwicklungen 4b durch jeweils einen Leiterdraht gebildet sein, der vollständig auf einem Oberflächenabschnitt einer Oberfläche des Vorrichtungskörpers 2 angebracht ist. Der Leiterdraht von jeder Wicklung4a, 4b in der Wicklungsstruktur 4 kann als Planarspulenabschnitt verlegt sein, vorzugsweise mit einem sinusförmigen Spulenverlauf im Planarspulenabschnitt für die Sekundärwicklungen 4b, wie in Fig. 1 gezeigt ist, während der Leiterdraht der Primärwicklung 4a kreisförmig verlegt ist, so dass die Sekundärwicklungen vollständig innerhalb der Primärwicklung 4a in dem Oberflächenabschnitt verlegt sind.

Wie in Fig. 1 dargestellt, kann die Erfassungsvorrichtung 10 in einigen beispielhaften Ausgestaltungen eine in dem Oberflächenabschnitt der Oberfläche des Vorrichtungskörpers 2 ausgebildete Nut 8 aufweisen. Die Nut 8 ist als eine Vertiefung in dem Verbindungskörper 2 ausgebildet, die im Spulenträgerkörperabschnitt 2a entsprechend einem Verlauf der Wicklungsstruktur 4 als ein dem Verlauf der Wicklungsstruktur 4 folgender Spulenaufnahmenutabschnitt 8a ausgebildet ist, um die Wicklungsstruktur 4 in den Spulenträgerkörperabschnitt 2a aufzunehmen, so dass die Wicklungsstruktur 4 durch den Spulenaufnahmenutabschnitt 8a in den Oberflächenabschnitt der Oberfläche des Vorrichtungskörpers 2 aufgenommen und eingebettet ist. Der Oberflächenabschnitt der Oberfläche des Vorrichtungskörpers 2 ist im Wesentlichen senkrecht zu einer Ebene orientiert, die im Wesentlichen durch die Wicklungsstruktur 4 festgelegt ist. Mit anderen Worten wird durch die Wicklungsstruktur 4 eine virtuelle Ebene dadurch festgelegt, dass die Wicklungsstruktur 4 im Wesentlichen in einer Ebene verlegt ist, die beispielsweise mit der Oberfläche des Vorrichtungskörpers 2 zusammenfallen kann, auf der die Wicklungsstruktur 4 angeordnet ist. Die Wicklungsstruktur 4 kann vollständig in der Nut 8 verlegt sein.

Im dargestellten Beispiel des ringförmigen Spulenträgerkörperabschnitts 2a ist der Spulenaufnahmenutabschnitt 8a als ringförmige Nut im Vorrichtungskörper 2 ausgebildet, der lateral durch Stegabschnitte 2c1 und 2c2 begrenzt ist. Im Allgemeinen kann mindestens ein Stegabschnitt entsprechend mindestens einem der Stegabschnitte 2c1 und 2c2 bereitgestellt sein, um die Nut 8 im Spulenträgerkörperabschnitt 2a wenigstens einseitig zu begrenzen. Dies stellt jedoch keine Beschränkung dar, da im Falle eines linearen Lagegebers ein linearer Spulenträgerkörperabschnitt ausgebildet ist, wobei ein entsprechend linear ausgebildeter Spulenaufnahmenutabschnitt gebildet ist.

Der Leiterplattenabschnitt 2b kann als ein plattenförmiger Vorsprung am Spulenträgerkörperabschnitt 2a ausgebildet sein, der flächenmäßig kleiner oder gleich oder größer sein kann als die Leiterplatte 6. Falls, wie in Fig. 1 dargestellt ist, der Leiterplattenabschnitt 2b größer gebildet ist als die Leiterplatte 6, kann die Leiterplatte 6 in einen im Leiterplattenabschnitt 2b ausgebildeten Leiterplattenaufnahmenutabschnitt 8b eingelegt sein, der im Leiterplattenabschnitt 2b gebildet ist. Der Leiterplattenaufnahmenutabschnitt 8b kann durch einen den Leiterplattenaufnahmenutabschnitt 8b wenigstens teilweise umgebenden Stegabschnitt 2d begrenzt sein. In anschaulichen Beispielen und wie in Fig. 1 dargestellt, kann der Leiterplattenaufnahmenutabschnitt 8b mit dem Spulenaufnahmenutabschnitt 8a kommunizierend verbunden sein, so dass die Nut 8 durch die Nutabschnitte 8a und 8b gebildet wird.

An dem Vorrichtungskörper 2 können ein oder mehrere Befestigungsabschnitte 9 jeweils mit einem Befestigungsloch 9a gebildet sein, die von dem Spulenträgerkörperabschnitt 2a seitlich abstehen und zur Befestigung der Erfassungsvorrichtung an einem weiteren Objekt (nicht dargestellt) verwendet werden kann. Das Befestigungsloch 9a kann mit einer Verstärkungsstruktur 9b, beispielsweise ein ins Befestigungsloch 9a eingesetzter Metallring, mit optionalem Innengewinde versehen sein.

Das mit Bezug auf Fig. 1 beschriebene Design ist optimiert, um die Kosten für die Herstellung der Erfassungsvorrichtung 10 zu minimieren, wobei die Leiterplatte 6 minimiert wird. Dazu sind die Primär- und Sekundärwicklungen 4a und 4b der Wicklungsstruktur 4 zumindest teilweise als Draht ausgeführt und jeweils durch einen Leiterdraht gebildet. Damit lässt sich die nötige Leiterplattenfläche für die Leiterplatte 6 auf ein Minimum reduzieren, da die Leiterplatte 6 nur noch für die Bestückung von diskreten Bauelemente wie eine integrierte Schaltung und schaltungstechnisch nötige Komponenten nötig ist.

Ein Verfahren zu Herstellung der Erfassungsvorrichtung 10 kann ein Bereitstellen eines wickelbaren Leiterdrahtes, ein Bereitstellen des Vorrichtungskörpers 2, ein Bereitstellen von einem von der Primärwicklung 4a und der wenigstens einen Sekundärwicklung 4b, wobei wenigstens eine von der Primärwicklung 4a und der wenigstens einen Sekundärwicklung 4b wenigstens teilweise durch den wickelbaren Leiterdraht auf einer Oberfläche des Vorrichtungskörpers 2 gebildet wird, und ein Bereitstellen der Leiterplatte 6 umfassen, die an dem Vorrichtungskörper 2 in Verbindung zu wenigstens einer von der Primärwicklung 4a und der wenigstens einen Sekundärwicklung 4b an dem Vorrichtungskörper 2 angebracht wird.

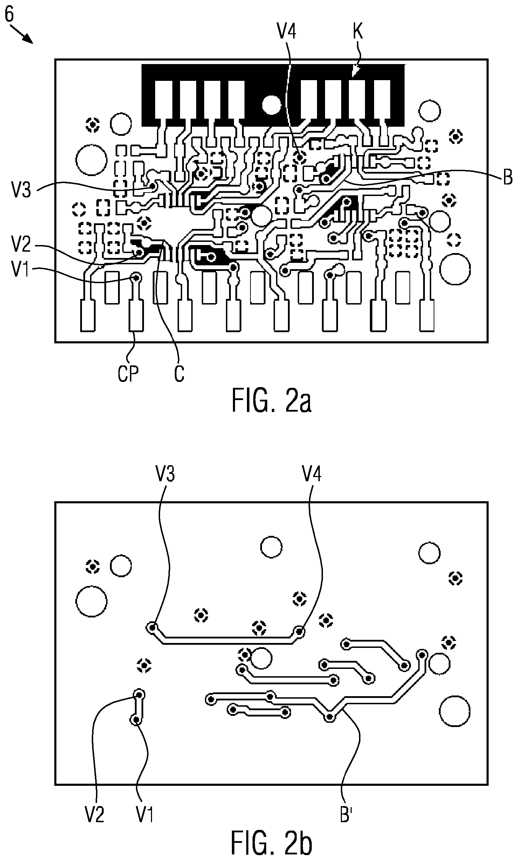

Mit Bezug auf Fig. 2a und 2b sind in Aufsichten zwei Lagen der Leiterplatte 6 dargestellt. Die Leiterplatte 6 kann entsprechend Fig. 2a und 2b ausschließlich Kontakte CP, diskrete elektrische Bauteile (wie Kondensatoren K und einen oder mehrere elektrische Widerstände) und eine integrierte Schaltung wie etwa einen Chip C aufweisen. Der Chip C kann wenigstens einen Teil einer integrierten Auswertungs- und/oder Ansteuerschaltung bereitstellen und mit der Primärwicklung 4a und den Sekundärwicklungen 4b mittels Kontakten CP und Leiterbahnen B verbunden sein.

In Fig. 2a kann eine obere Lage der Leiterplatte 6 dargestellt sein, wobei Vias V1, V2, V3, V4 die obere Lage mit einer in Fig. 2b dargestellten unteren Lage verbunden, so dass eine Leiterplattenfläche der Leiterplatte 6 minimiert werden kann. Die Vias V1 bis V4 können Leiterbahnen B auf der oberen Lage mit Leiterbahnen B' der unteren Lage verbinden.

In anschaulichen Beispielen kann die Leiterplatte 6 beispielsweise eine Größe von 45x29 mm = 1.300 mm² aufweisen, was einer Reduzierung einer in herkömmlichen Anwendungen verwendeten Leiterplatte mit einer Größer von mehr als 19.000 mm² von ca. 93% entspricht. Zusätzlich kann auch noch die Lagenanzahl der Leiterplatte 6 von bisher vier Lagen in herkömmlichen Leiterplatten auf zwei Lagen für die Leiterplatte 6 reduziert werden, was ebenfalls eine Preisreduktion der Leiterplatte 6 gegenüber herkömmlichen Leiterplatten bewirkt.

In einigen beispielhaften Ausführungsformen kann die Erfassungsvorrichtung 10 einen Rotorlagegeber einer elektrischen Maschine darstellen. Dabei kann eine Geberstruktur (nicht dargestellt) an einer axialen Oberfläche eines Läufers (nicht dargestellt), beispielsweise ein Rotor einer elektrischen Maschine (nicht dargestellt), angebracht und mit diesem bewegbar sein. In anschaulichen Beispielen kann die elektrische Maschine (nicht dargestellt) eine permanentmagnetisch erregte Maschine sein, in der ein Winkelsignal zur elektrischen Kommutierung verwendet wird. Weiterhin ist die Erfassungsvorrichtung 10 bereitgestellt, die der Geberstruktur (nicht dargestellt) axial gegenüberliegend angeordnet sein kann. Die Geberstruktur (nicht dargestellt) und die Erfassungsvorrichtung 10 bilden ein Erfassungssystem für den Rotorlagegeber, wobei die Geberstruktur (nicht dargestellt) relativ zu der Erfassungsvorrichtung 10 drehbar angeordnet ist.

Gemäß anschaulichen Beispielen hierin kann die Geberstruktur (nicht dargestellt) auf einem geeigneten Trägermaterial (nicht dargestellt) aufgebracht oder direkt in einem Basismaterial des Rotors (nicht dargestellt), der auf einer Welle (nicht dargestellt) sitzt, angebracht sein. Unter einem Basismaterial des Rotors (nicht dargestellt) kann ein Material verstanden werden, das für die Funktion des Rotors (nicht dargestellt) vorgesehen ist, wie z.B. ein Material zur Halterung von Komponenten (nicht dargestellt) der elektrischen Maschine (nicht dargestellt), wie etwa Magnete und dergleichen.

Beispielsweise umfasst die Erfassungsvorrichtung 10 eine Mehrzahl von Wicklungen (nicht dargestellt) und eine elektronische Schaltung (nicht dargestellt), die von den Wicklungen ausgegebene Signal verarbeitet und als Positionssignale ausgibt, wie z.B. elektrische Signale wie Spannungsamplituden, Differenzspannungen, Stromamplituden, Differenzströme, Frequenzen, Phasenlagen usw., wobei aus diesen elektrischen Signale eine Drehwinkellage des Rotors (nicht dargestellt) relativ zur Erfassungsvorrichtung 10 ableitbar ist.

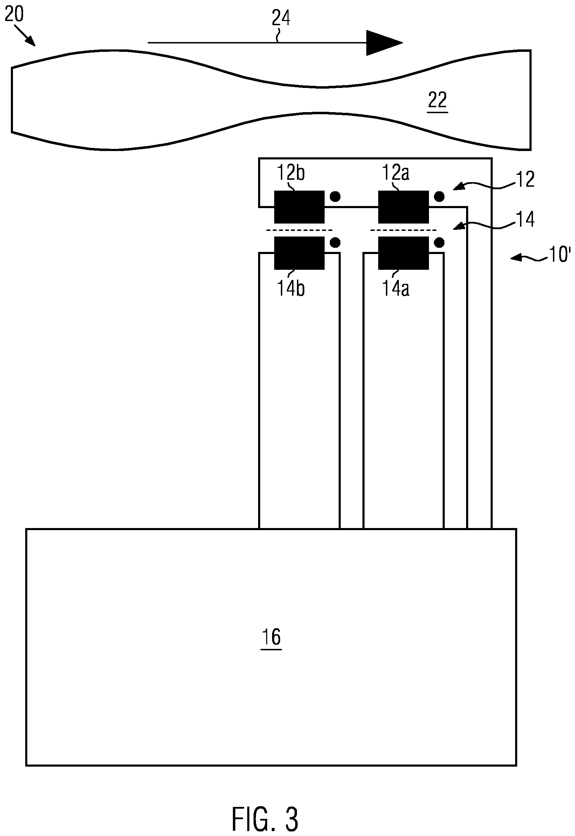

Mit Bezug auf Fig. 3 ist ein Erfassungssystem 20 mit einer Erfassungsvorrichtung 10' und einem Geberelement dargestellt, welches anhand einer Geberstruktur 22 des Geberelements in Fig. 3 veranschaulicht wird. Zwar ist die Geberstruktur 22 als eine sich sinusförmig ändernde Struktur dargestellt, doch stellt dies keine Beschränkung dar und es können alternative Geberstrukturen eingesetzt werden, wie Beispielsweise eine rechteckige Geberstruktur die kleiner ist als eine Periode der Wicklungsstruktur. Eine Bewegungsrichtung, beispielsweise eine Drehrichtung für einen Rotorlagegeber, in der sich das Geberelement relativ zu der Erfassungsvorrichtung 10' bewegt, ist in Fig. 3 schematisch anhand eines Pfeils 24 zur Veranschaulichung gezeigt.

Die Erfassungsvorrichtung 10' kann der Erfassungsvorrichtung 10 entsprechen, die mit Bezug auf die Fig. 1 bis 2 oben beschrieben ist, wobei mit Bezug auf die Erfassungsvorrichtung 10 beschriebene strukturelle und funktionale Elemente sich auf die Erfassungsvorrichtung 10'übertragen soweit es nicht anderweitig im Folgenden explizit beschrieben ist.

Gemäß der Darstellung in Fig. 3 weist die Erfassungsvorrichtung 10' eine Mehrzahl von Primärwicklungen 12 und eine Mehrzahl von Sekundärwicklungen 14 auf. Diese Wicklungen sind auf einem Vorrichtungskörper angebracht. Die Mehrzahl von Primärwicklungen 12 kann zwei Primärwicklungen 12a bis 12b aufweisen, obgleich dies keine Beschränkung darstellt und stattdessen eine die Sekundärwicklungen überlagernde Primärwicklung bereitgestellt sein kann. Die Mehrzahl von Sekundärwicklungen 14 weist zwei Sekundärwicklungen 14a und 14b auf, obgleich die keine Beschränkung darstellt und stattdessen auch vier oder mehr Sekundärwicklungen bereitgestellt sein können. Die Anzahl von Sekundärwicklungen ist daher nicht auf zwei beschränkt und es kann alternativ ein Vielfaches von vier Sekundärwicklungen vorgesehen sein.

Wie weiter oben angemerkt, kann die Erfassungsvorrichtung 10' entsprechend der Erfassungsvorrichtung 10 ausgebildet sein. Dies stellt jedoch keine Beschränkung dar und alternativ kann die Erfassungsvorrichtung 10' in einer alternativen Ausgestaltung bezüglich der Erfassungsvorrichtung 10 ausgeführt sein, wobei die Erfassungsvorrichtung 10' wenigstens zwei miteinander elektrisch verbundene Leiterplatten (in der schematischen Darstellung von Fig. 3 nicht gezeigt) umfasst. Dabei kann wenigstens eine von Primärwicklung 12 und Sekundärwicklungen 14 als eine wenigstens teilweise integrierte Verdrahtung ausgeführt sein, die wenigstens teilweise in wenigstens eine der wenigstens zwei Leiterplatten integriert ist.

In anschaulichen Beispielen können weiterhin die wenigstens zwei Leiterplatten eine Leiterplatte mit lediglich zwei Lagen und eine Leiterplatte mit mehr als zwei Lagen umfassen. Beispielsweise kann in die Leiterplatte mit mehr als zwei Lagen ferner wenigstens ein Teil einer Auswertungs- und Ansteuerschaltung für eine oder mehrere der damit verbundenen Wicklungen 12, 14 integriert sein und/oder wenigstens eine der Wicklungen 12, 14 kann vollständig in die Leiterplatte mit lediglich zwei Lagen integriert sein. Weiterhin kann die Erfassungsvorrichtung 10'ferner einen Vorrichtungskörper umfassen, wie etwa einen Spritzgusskörper wie mit Bezug auf die Erfassungsvorrichtung 10 oben beschrieben ist, abgesehen davon, dass an dem Vorrichtungskörper die wenigstens zwei Leiterplatten angebracht sind, und/oder wobei wenigstens eine von der Primärwicklung 12 und der Sekundärwicklungen 14 höchstens teilweise durch einen Leiterdraht ausgebildet ist.

Ein Verfahren zur Herstellung der Erfassungsvorrichtung 10' kann ein Bereitstellen eines wickelbaren Leiterdrahtes, ein Bereitstellen des Vorrichtungskörpers 2, Bereitstellen von der Primärwicklung 12 und/oder der wenigstens einen Sekundärwicklung 14, wobei wenigstens eine von der Primärwicklung 12 und der wenigstens einen Sekundärwicklung 14 wenigstens teilweise durch den wickelbaren Leiterdraht auf einer Oberfläche des Vorrichtungskörpers 2 gebildet wird, und ein Bereitstellen der Leiterplatte 6 umfasst, die an dem Vorrichtungskörper 2 in Verbindung zu wenigstens einer von der Primärwicklung 12 und der wenigstens einen Sekundärwicklung 14 an dem Vorrichtungskörper 2 angebracht wird.

Wie oben beschrieben ist kann eine Anzahl von Primärwicklungen bereitgestellt sein, die der Anzahl von Sekundärwicklungen 1:1 entspricht. Alternativ kann eine Untergruppe von Sekundärwicklungen aus der Mehrzahl von Sekundärwicklungen genau einer Primärwicklung zugeordnet sein. Beispielsweise kann je eine Primärwicklung aus einer Mehrzahl von Primärwicklungen zwei oder mehr Sekundärwicklungen zugeordnet sein, so dass jede Primärwicklung einer Untergruppe von Sekundärwicklungen zugeordnet ist, wobei jede Untergruppe eine gleiche Anzahl von Sekundärwicklungen aufweist.

Mit weiterem Bezug auf Fig. 3 kann mittels der Leiterplatte 16 eine elektronische Schaltung vorgesehen sein, die einerseits ein elektrisches Signal an die Mehrzahl von Primärwicklungen 12 anlegt, andererseits durch die Mehrzahl von Sekundärwicklungen 14 ausgegebene elektrische Signale empfängt. Beispielsweise kann die elektronische Schaltung eine Oszillatorschaltung aufweisen, die in die Leiterplatte 16 integriert oder damit gekoppelt ist und durch die eine periodisches elektrisches Signal an die Mehrzahl von Primärwicklungen 12 angelegt wird.

Die Mehrzahl von Primärwicklungen 12 kann beispielsweise in einer Resonatorschaltung verschaltet sein, die durch die in die Leiterplatte 16 integrierte Oszillatorschaltung (nicht dargestellt) gespeist wird. Beispielsweise kann die Mehrzahl von Primärwicklungen 12 durch eine Reihenschaltung der Primärwicklungen 12a und 12b gebildet sein. Dies stellt jedoch keine Beschränkung dar und es kann eine geeignete Parallelschaltung der Primärwicklungen 12a und 12b vorgesehen sein.

Die Sekundärwicklungen 14a und 14b der Mehrzahl von Sekundärwicklungen 14 können in Untergruppen aus je zwei in Reihe geschalteten Sekundärwindungsgruppen unterteilt sein, die separat mit der Leiterplatte 16 verbunden sind. Beispielsweise kann die Sekundärwicklung 14a durch zwei oder mehr zueinander in Reihe geschaltete Sekundärwindungsgruppen gebildet sein, während die Sekundärwicklungen 14b durch eine andere Untergruppe von Sekundärwindungen gebildet sein kann. Jede dieser Untergruppen stellt für die Leiterplatte 16 elektrische Signale bereit, auf deren Basis eine Winkellagebestimmung in dem Erfassungssystem 20 erfolgen kann. Die Sekundärwindungen in jeder Untergruppe können derart relativ zueinander gewickelt und miteinander verschaltet sein, dass ein von einer Untergruppe ausgegebenes Spannungssignal ein Differentialsignal an einem Kontakt der Leiterplatte 16 darstellt. Dies bedeutet, dass ein Spannungssignal, das durch eine Untergruppe ausgegeben wird, einer Differenz aus Spannungen entspricht. Damit kann ein von einer Untergruppe ausgegebenes Spannungssignal einer Spannungsdifferenz entsprechen, wobei beispielsweise das von einer Untergruppe ausgegebene Spannungssignal gegenüber dem von einer anderen Untergruppe ausgegebenen Spannungssignal phasenverschoben derart ist, dass ein Signal ein sinusförmiges Signal darstellen kann, während das andere Signal ein cosinusförmiges Signal darstellen kann.

Hinsichtlich der anhand von Fig. 3 beschriebenen Ausführungsformen bedeutet dies, dass alle Primärwicklungen 12 und alle Sekundärwicklungen 14 gleichen Wicklungssinn relativ zueinander aufweisen, jedoch die Sekundärwicklungen 14 jeweils derart Untergruppen miteinander verschaltet sind, dass Differentialsignale durch die Leiterplatte 16 abgegriffen werden können. An der Leiterplatte können daher von den Sekundärwicklungen beispielsweise Signale proportional zu einem sinusförmigen Signal und einem cosinusförmigen Signal bereitgestellt werden, so dass an der Leiterplatte ein Winkelsignal eingegeben werden kann.

Im Hinblick auf andere Ausgestaltungen der Geberstruktur 22, die von der dargestellten Geberstruktur 22 verschieden sind (wie weiter oben hinsichtlich verschiedener Ausgestaltungen von Geberstrukturen beschrieben ist), kann eine geeignete Form für die Sekundärwicklungen und Primärwicklungen gewählt werden, beispielsweise in Form von sinusförmigen Spulen oder rechteckförmigen Spulen.

In einigen anschaulichen Ausführungsformen ist die Mehrzahl von Primärwicklungen 12 bezüglich der Mehrzahl von Sekundärwicklungen 14 derart angeordnet, dass je eine der Primärwicklungen 12a und 12b und je eine der Sekundärwicklungen 14a und 14b in einem Spulenpaar angeordnet sind, so dass diese Wicklungen im Spulenpaar eine maximale induktive Kopplung im Vergleich zu einer induktiven Kopplung zwischen einer Wicklung aus diesem Spulenpaar und einer Wicklung aus einem anderen Spulenpaar aufweisen. Beispielsweise bedeutet dies konkret, dass die Primärwicklung 12a und die Primärwicklung 14a ein Spulenpaar 12a, 14a bilden, das dadurch ausgezeichnet ist, dass eine induktive Kopplung zwischen der Primärwicklung 12a und der Sekundärwicklung 14a im Vergleich zu einer induktiven Kopplung zwischen der Primärwicklung 12a und der Sekundärwicklung 14b und auch zu einer induktiven Kopplung zwischen der Sekundärwicklung 14a und der Primärwicklung 12b maximal ist. Entsprechend können auch die verbliebenen Wicklungen 12b und 14b paarweise in Spulenpaaren angeordnet sein. Dies kann gemäß einem speziellen anschaulichen (aber nicht beschränkenden Beispiel) in einer Anordnung der Wicklungen realisiert sein, in der sich je eine Primärwicklung und je eine Sekundärwicklung unmittelbar gegenüberliegen oder miteinander verschränkt sind. Dadurch werden durch jedes Spulenpaar maximale Signalstärken erzeugt, so dass wenig bis keine Verstärkung durch von Spulenpaaren erzeugten Signalen erforderlich ist. In weiteren anschaulichen Beispielen können die Primär- und Sekundärwicklungen in einem Spulenpaar deckungsgleich sein.

Hinsichtlich der in den verschiedenen anschaulichen Ausführungsformen oben sind Wicklungen anhand von Primär- und Sekundärwicklungen beschrieben. Wenigstens ein Teil dieser Wicklungen kann beispielsweise als eine Luftspule ausgebildet sein. Dies bedeutet, dass kein magnetisierbarer Kern vorgesehen ist.

Hinsichtlich einiger anschaulicher Ausführungsformen sind oben "sinusförmige" Spulen beschrieben. Dabei wird unter den Begriff "sinusförmig" allgemein eine Form verstanden, die sich zumindest einmal wiederholt, wobei eine Länge der Form in einem maximalen Längenintervall, in dem keine Wiederholung der Form auftritt, als eine Periode bezeichnet wird. In speziellen anschaulichen Beispielen kann auch eine "cosinusförmige" Gestalt als unter den Begriff "sinusförmig" fallend angesehen werden, da Sinus und Cosinus für einen Winkel φ bekanntermaßen durch eine Phasenverschiebung um 90° bzw. einem Viertel einer Periode auseinander hervorgehen: cos φ = sin (φ+90°).

Der Begriff "im Wesentlichen" soll zum Ausdruck bringen, dass auch Abweichungen und Modifikationen möglich sind, die die Funktion oder den zu erzielenden Effekt wenig bis gar nicht beeinflussen. Dabei werden Abweichungen in einem Bereich von 50%, etwa von höchstens 25% oder von höchstens 15% oder von höchstens 10% oder von höchstens 5% oder von höchstens 1% als tolerierbar angesehen.

Im Hinblick auf verschiedene Ausführungsformen einer Erfassungsvorrichtung mit in Untergruppe verschalteten Sekundärwicklungen ist allgemein aus der obigen Beschreibung zu entnehmen, dass Primärwicklungen und Sekundärwicklungen jeweils mit einem bestimmten Wicklungssinn bzw. Windungssinn derart gekoppelt und/oder verschaltet sein können, so dass in jeder der Primärwicklungen, die einer bestimmten Untergruppe von Sekundärwicklungen zugeordnet sind, jeweils ein magnetisches Feld erzeugt wird, das wiederrum in der jeweiligen zugeordneten Sekundärwicklung dieser bestimmten Untergruppe eine Spannung derart induziert, dass an Anschlussenden dieser bestimmten Untergruppe zur Leiterplatte eine Spannungsdifferenz aus den Spannungen auftritt, die in den einzelnen Sekundärwicklungen dieser bestimmten Untergruppe entsprechend induziert werden. Damit kann ein von einer Untergruppe ausgegebenes Spannungssignal einer Spannungsdifferenz entsprechen, wobei beispielsweise das von einer Untergruppe ausgegebene Spannungssignal gegenüber dem von einer anderen Untergruppe ausgegebenen Spannungssignal phasenverschoben derart ist, dass ein Signal ein sinusförmiges Signal darstellen kann, während das andere Signal ein cosinusförmiges Signal darstellen kann.

Obgleich mit Bezug auf die Figuren Anwendungen hinsichtlich eines Rotorlagegebers beschrieben sind, stellt dies keine Beschränkung dar. Anstelle eines Rotorlagegebers kann die Erfindung auf einen Lagegeber angewendet werden, der nicht direkt eine Lage eines Rotors einer elektrischen Maschine, sondern eine Lage eines beliebigen rotierenden Teils erfasst, wie etwa eines Teils, das beispielsweise über ein Getriebe an einen Rotor einer elektrischen Maschine angeflanscht ist, oder ein rotierendes Teil, welches nur in einem begrenzten Winkelbereich oder kontinuierlich rotiert, wie z.B. ein beliebiges rotierendes Stellelement.

## Patentansprüche

1. Erfassungsvorrichtung (10; 10') für einen Lagegeber, vorzugsweise einen Rotorlagegeber, mit einer Leiterplatte (6; 16), umfassend:
eine Primärwicklung (4a; 12) und wenigstens eine Sekundärwicklung (4b; 14), wobei wenigstens eine von der Primärwicklung (4a; 12) und der wenigstens einen Sekundärwicklung (4b; 14) wenigstens teilweise durch einen wickelbaren Leiterdraht ausgebildet ist; und
einen Vorrichtungskörper (2), wobei der Leiterdraht der Primärwicklung (4a; 12) und/oder der wenigstens einen Sekundärwicklung (4b; 14) vollständig auf einem Oberflächenabschnitt einer Oberfläche des Vorrichtungskörpers (2) angebracht ist.

2. Erfassungsvorrichtung (10; 10') nach Anspruch 1, wobei der der Leiterdraht als Planarspulenabschnitt verlegt ist, vorzugsweise mit einem sinusförmigen Spulenverlauf im Planarspulenabschnitt.

3. Erfassungsvorrichtung (10; 10') nach Anspruch 1 oder 2, wobei der Vorrichtungskörper (2) eine Nut (8) aufweist, in der der Leiterdraht der Primärwicklung (4a; 12) und/oder der wenigstens einen Sekundärwicklung (4b; 14) vollständig verlegt ist.

4. Erfassungsvorrichtung (10; 10') nach Anspruch 3, wobei die Nut (8) einen Spulenaufnahmenutabschnitt (8a) aufweist, vorzugsweise ausgebildet als ringförmiger Nutabschnitt im Vorrichtungskörper (2), der lateral durch Stegabschnitte (2c1, 2c2) in der Oberfläche des Vorrichtungskörpers (2) begrenzt ist.

5. Erfassungsvorrichtung (10; 10') nach Anspruch 3 oder 4, wobei die Nut (8) ferner einen Leiterplattenaufnahmenutabschnitt (8b) aufweist, der zur vollständigen Aufnahme einer Leiterplatte (6) ausgebildet ist, wobei die Nut (8) lediglich auf einer Oberfläche des Vorrichtungskörpers (2) ausgebildet ist.

6. Erfassungsvorrichtung (10; 10') nach einem der Ansprüche 1 bis 5, wobei der Vorrichtungskörper (2) als ein plattenförmiger oder scheibenförmiger Körper ausgebildet ist und die Nut (8) in einer Oberfläche des Vorrichtungskörpers (2) gebildet ist, die senkrecht zu einer kleinsten Abmessung des Vorrichtungskörpers (2) orientiert ist.

7. Erfassungsvorrichtung (10; 10') nach einem der Ansprüche 1 bis 6, ferner umfassend eine Leiterplatte, die an dem Vorrichtungskörper (2) angebracht und mit der Primärwicklung (4a; 12) und/oder der wenigstens einen Sekundärwicklung (4b; 14) auf dem Vorrichtungskörper (2) verbunden ist.

8. Erfassungsvorrichtung (10; 10') nach Anspruch 7, wobei die Leiterplatte einen Flächenbereich des Vorrichtungskörpers (2) von weniger als 19.000 mm², vorzugsweise höchstens 18.500 mm² und weiter bevorzugt höchstens 3.000 mm² bedeckt, und/oder wobei die Leiterplatte (6) weniger als vier Lagen umfasst.

9. Erfassungsvorrichtung (10; 10') nach Anspruch 7 oder 8, wobei die Leiterplatte (6) ausschließlich Kontakte (CP), diskrete elektrische Bauteile, vorzugsweise wenigstens einen Kondensator (K) und/oder wenigstens einen Widerstand, und eine integrierte Schaltung (C) aufweist, die wenigstens als Teil einer integrierten Auswertungs- und/oder Ansteuerschaltung mit der Primärwicklung (4a; 12) und/oder der wenigstens einen Sekundärwicklung (4b; 14) verbunden ist, wobei diese über Kontakte (CP) durch Leiterbahnen (B, B') mit den elektrischen Bauteilen verbunden sind.

10. Erfassungsvorrichtung für einen Lagegeber, vorzugsweise einen Rotorlagegeber, umfassend:
wenigstens zwei miteinander elektrisch verbundene Leiterplatten; und
eine Primärwicklung und wenigstens eine Sekundärwicklung, wobei wenigstens eine von der Primärwicklung und der wenigstens einen Sekundärwicklung als eine wenigstens teilweise integrierte Verdrahtung wenigstens teilweise in wenigstens eine der wenigstens zwei Leiterplatten integriert ist.

11. Erfassungsvorrichtung nach Anspruch 10, wobei die wenigstens zwei Leiterplatten eine Leiterplatte mit lediglich zwei Lagen und eine Leiterplatte mit mehr als zwei Lagen umfassen.

12. Erfassungsvorrichtung nach Anspruch 11, wobei in die Leiterplatte mit mehr als zwei Lagen ferner wenigstens ein Teil einer Auswertungs- und Ansteuerschaltung für eine oder mehrere der damit verbundenen Wicklungen integriert ist und/oder wenigstens eine Wicklung vollständig in die Leiterplatte mit lediglich zwei Lagen integriert ist.

13. Erfassungsvorrichtung nach einem der Ansprüche 10 bis 12, ferner umfassend einen Vorrichtungskörper, vorzugsweise einen Spritzgusskörper, an dem die wenigstens zwei Leiterplatten angebracht sind, und/oder wobei wenigstens eine von der Primärwicklung und der wenigstens einen Sekundärwicklung höchstens teilweise durch einen wickelbaren Leiterdraht ausgebildet ist.

14. Erfassungssystem, umfassend:
eine Erfassungsvorrichtung nach einem der Ansprüche 1 bis 13; und
ein Geberelement, das relativ zur Erfassungsvorrichtung drehbar angeordnet ist,
wobei das Geberelement eine Geberstruktur aufweist, die aus einem elektrisch leitfähigen Material gebildet ist.

15. Verfahren zur Herstellung einer Erfassungsvorrichtung (10; 10') für einen Lagegeber, vorzugsweise einen Rotorlagegeber, mit einer Leiterplatte (6; 16), wobei das Verfahren umfasst:
Bereitstellen eines wickelbaren Leiterdrahtes,
Bereitstellen eines Vorrichtungskörpers (2),
Bereitstellen von einer Primärwicklung (4a; 12) und/oder wenigstens einer Sekundärwicklung (4b; 14), wobei wenigstens eine von der Primärwicklung (4a; 12) und der wenigstens einen Sekundärwicklung (4b; 14) wenigstens teilweise durch den wickelbaren Leiterdraht auf einer Oberfläche des Vorrichtungskörpers (2) gebildet wird, und
Bereitstellen einer Leiterplatte (6), die an dem Vorrichtungskörper (2) in Verbindung zu wenigstens einer von der Primärwicklung (4a; 12) und der wenigstens einen Sekundärwicklung (4b; 14) an dem Vorrichtungskörper (2) angebracht wird.
